# EUROPÄISCHE PATENTSCHRIFT

(11) **EP 0 664 923 B1**
(45) Veröffentlichungstag und Bekanntmachung des Hinweises auf die Patenterteilung: **06.06.2001**
(21) Anmeldenummer: 93924036.2
(22) Anmeldetag: 13.10.1993
(51) Int. Cl.: H01L 21/48, H05K 13/00

(54) **VERFAHREN UND VORRICHTUNG ZUM FORMEN DER ANSCHLUSSBEINCHEN VON INTEGRIERTEN SCHALTKREISEN**
PROCESS AND DEVICE FOR FORMING THE CONNECTION LEADS OF INTEGRATED CIRCUITS
PROCEDE ET DISPOSITIF PERMETTANT DE FORMER DES CONDUCTEURS DE RACCORDEMENT DE CIRCUITS INTEGRES

(30) Priorität: 14.10.1992 DE 4234697
(43) Veröffentlichungstag der Anmeldung: 02.08.1995
(73) Patentinhaber: MICRON TECHNOLOGY INC., Boise, ID 83706-9698 (US)
(72) Erfinder: HINTERLECHNER, Gerhard, D-75180 Pforzheim (DE)
(74) Vertreter: Twelmeier, Ulrich, Dipl.Phys.
(86) Internationale Anmeldenummer: EP9302819
(87) Internationale Veröffentlichungsnummer: WO9409510

(56) Entgegenhaltungen:
- EP-A- 0 330 512
- EP-A- 0 513 425
- PATENT ABSTRACTS OF JAPAN vol. 14, no. 103 (M-941)26. Februar 1990 & JP,A,01 309 725 (TEIJIN SEIKI CO LTD) 14. Dezember 1989
- PATENT ABSTRACTS OF JAPAN vol. 10, no. 272 (E-437)(2328) 16. September 1986 & JP,A,61 095 560 (HITACHI LTD) 14. Mai 1986
- IBM TECHNICAL DISCLOSURE BULLETIN. Bd. 28, Nr. 7 , Dezember 1985 , NEW YORK US Seite 3019 'Integrated Circuit Lead_Forming Mechanism'

## Beschreibung

Die Erfindung geht aus von einem Verfahren mit den im Oberbegriff des Anspruchs 1 angegebenen Merkmalen und von einer Vorrichtung mit den im Oberbegriff der Ansprüche 6 oder 7 angegebenen Merkmalen.

Integrierte Schaltkreise IC's (Integrated Circuits) werden überwiegend auf Trägerstreifen aufgebaut und mit einem Plastikgehäuse umspritzt. Der Trägerstreifen ist ein Metalland, auf welchem die Strukturen der Anschlußbeinchen durch Ätzen oder Stanzen gebildet werden. Die Anschlußbeinchen (Leads) sind seitlich am Gehäuse in einer gemeinsamen Ebene angeordnet. Um die IC's auf eine Schaltunsträgerplatte löten zu können, müssen die zunächst ebenen Anschlußbeinchen in eine dafür geeignete Form gebogen werden. Dabei sind die Gehäuse noch über Stege an den Gehäuseecken mit dem Trägerstreifen verbunden. Je mehr Beinchen die IC's haben und je dichter diese nebeneinander angeordnet sind, desto größer sind die Anforderungen an die Genauigkeit beim Biegen, denn schon kleinste Abweichungen in den Biegewinkeln und Schieflagen der Beinchen führen zu fehlerhaften Kontaktierungen auf der Schaltungsträgerplatte. Die Biegewerkzeuge für die Beinchen sind deshalb Präzisionswerkzeuge. Besonders hohe Anforderungen an die Präzision der Biegewerkzeuge stellen moderne hochintegrierte IC's mit weit über hundert Anschlußbeinchen.

Die Beinchen werden meist Z-förmig mit zwei annähernd rechten Winkeln gebogen. Um das zu erreichen, ist es bekannt, die Anschlußbeinchen nahe am Gehäuse gegen eine Biegematrize zu klemmen und mit einem Biegestempel ca. 45 Grad nach unten gegen die komplementäre Biegefläche der Matrize zunächst schräg abzubiegen. Die IC's werden dann, noch immer mit dem Leadframe verbunden, in ein benachbartes Gesenk überführt, in welchem die Beinchen zwischen einer Biegematrize und schräg geführten Biegestempeln in ihre endgültige Gestalt gebogen werden. Zu diesem Zweck hat die Biegematrize eine der gewünschten Z-Form der Beinchen angepaßte Form, in welche ein Oberstempel schräg von oben, mit seiner Spitze gegen den Scheitel der Form der Biegematrize gerichtet, hineingedrückt wird und dadurch die Beinchen in die Ausnehmung der Biegeform der Matrize drückt. Es kommt dabei unvermeidlich durch eine relativ hohe Flächenpressung zwischen den Beinchen und dem Biegewerkzeug sowie durch eine Reibung aus der Relativbewegung zwischen den Beinchen und dem Werkzeug zu einem Abrieb von Zinn, welches sich für den späteren Lötvorgang bereits als Beschichtung auf den Beinchen befindet. Das abgeriebene Zinn lagert sich auf dem Werkzeug ab und führt dazu, dass bereits nach relativ kurzer Zeit, nämlich nach wenigen tausend Hüben des Werkzeugs, welches über DM 100.000,-- kostet, das Werkzeug gewechselt und gereinigt werden muss. Bei einer Arbeitsgeschwindigkeit von zwei Hüben pro Sekunde benötigt man für 1000 Hübe nur 8 Minuten, so dass man für jede Maschine ständig mehrere Personen zum Putzen des Werkzeugs und mehrere Werkzeugsätze benötigt. Das hat nicht nur hohe Personalkosten und Werkzeugkosten zur Folge, sondern durch die häufigen Wekzeugwechsel auch relativ lange Stillstandszeiten, welche die Chipfertigung erheblich verteuern, ganz abgesehen davon, dass jeder Werkzeugwechsel durch Fehljustierung bei der Montage zu Schäden an den IC's bzw. an dem Werkzeug selbst führen kann. Nimmt man um einem zu häufigen Werkzeugwechsel zu entgehen, eine stärkere Zinnablagerung auf dem Biegewerkzeug in Kauf, geht das auf Kosten der Biegepräzision mit der Folge, dass die abgebogenen Enden der Beinchen nicht alle in einer gemeinsamen Ebene liegen, was für das Auflöten auf eine Schaltungsträgerplatte unabdingbar ist. Bei den bekannten Biegevorrichtungen kommt noch hinzu, dass durch den Biegevorgang selbst einzelne Beinchen, Gruppen von Beinchen oder alle Beinchen nicht senkrecht zur ursprünglichen gemeinsamen Ebene der Beinchen, sondern etwas schräg dazu abgebogen werden können, insbesondere wenn die Beinchen, welche durch Ätzen hergestellt werden, einen von der rechteckigen Form abweichenden Querschnitt aufweisen. Das Ergebnis ist dann eine Fehllage der abgebogenen Enden der Beinchen, insbesondere auch eine mangelhafte Koplanarität. Diese Fehllage kann beim Bestücken von Schaltungsträgerplatten mit einem Bestückungsautomaten nicht ausgeglichen werden. Chiphersteller verwenden deshalb viel Mühe und Aufwand darauf, die exakte Lage der abgebogenen Enden der Beinchen zu überprüfen und ggfs. zu korrigieren (vgl. Z.: "SEMICONDUCTOR INTERNATIONAL" Mai 1992, Seiten 86 bis 90, insbesondere Seite 90, mittlere Spalte, vorletzter Absatz).

Aus der prioritatsälteren, nach veröffentlichten EP-A-0 513 425 sind eine Vorrichtung gemäß den Oberbegriff des Anspruchs 7 und ein Verfahren zum Formen der Anschlußbeinchen von integrierten Schaltkreisen bekannt, bei dem die Beinchen des integrierte Schaltkreis in einigem Abstand von dessen gehäuse eingeklemmt und dann die Beinchen unter Aufrechterhaltung der Klemmung entlang einem bogenförmigen Weg, welcher in einer die jeweiligen Beinchen enthaltenden, rechtwinkelig zu einer die Beinchen enthaltenden Ebene verlaufenden Ebene liegt, zwangsgeführt werden. Nachteilig deren ist, daß aufgrund dieses Biegens der Beichen in freien Raum ein wiederholbarer, gleichmäßiger Biegevorgang nicht oder nur schwer erzielbar ist.

Aus JP-A-01 309 725 ist eine Vorrichtung gemäß den Oberbegriff des Anspruchs 6 bekannt.

Der vorliegenden Erfindung liegt die Aufgabe zugrunde, die Genauigkeit beim Biegen der Anschlußbeinchen von IC's zu erhöhen und die Notwendigkeit von Werkzeugwechseln zum Zwecke der Reinigung von Zinnablagerungen auf den Biegeeinsätzen der Werkzeuge zu verringern.

Diese Aufgabe wird gelöst durch ein Verfahren mit den im Anspruch 1 angegebenen Merkmalen sowie durch eine Vorrichtung mit den im Anspruch 6 oder 7 angegebenen Merkmalen. Vorteilhafte Weiterbildungen der Erfindung sind Gegenstand der abhängigen Ansprüche.

Die vorliegende Erfindung vollzieht eine Abkehr von der bisher üblichen Vorgehensweise, die Beinchen in einem Gesenk zu formen, in dem sie lediglich mit einem Biegestempel in eine Ausnehmung einer Matrizenform gedrückt werden; vielmehr werden die Beinchen an ihren freien Enden in einem Klemmwerkzeug eingeklemmt und die eingeklemmten Enden der Beinchen dann entlang einem bogenförmigen Weg, ohne seitliche Abweichung, zwangsgeführt. Dadurch erreicht man, dass die Enden der Beinchen, die für das automatisierte Auflöten der IC's auf Schaltungsträgerplatten in genau bestimmter Lage in einer gemeinsamen Ebene liegen müssen, durch das Klemmwerkzeug zwangsgeführt werden und - anders als beim Stand der Technik - keine Möglichkeit des seitlichen Ausweichens während des Biegevorganges haben, so dass sie ihre vorbestimmte Lage zwangsläufig erreichen. Da das Biegen mit Hilfe des Klemmwerkzeugs durchgeführt wird und das Klemmwerkzeug die Enden der Beinchen festhält, tritt zwischen dem Werkzeug und den Beinchen keine Verschiebung, keine Relativbewegung und daher keine Reibung auf. Verglichen mit der Arbeitsweise beim Stand der Technik ist deshalb die Gefahr, dass von den Beinchen Zinn abgerieben wird und sich auf dem Werkzeug ablagert, äußerst gering, so dass die Arbeitszeiten, nach denen vielleicht doch einmal die Reinigung eines Werkzeugs erforderlich wird, gegenüber dem Stand der Technik drastisch verlängert werden. Der Aufwand für das Reinigen der Werkzeuge ist deshalb äußerst gering, und entsprechendes gilt für die durch Reinigungsarbeiten bedingten Stillstandszeiten (Umrüstzeiten) der Maschine. Durch die Zwangsführung der Beinchen an ihren Enden sind darüberhinaus Fehllagen der Enden nach dem Biegen, hervorgerufen durch unregelmäßige Beinchenquerschnitte, sehr unwahrscheinlich, weil Abweichungen durch die Zwangsführung der Enden der Beinchen verhindert werden. Nachträgliche Korrekturen von Fehllagen der Beinchen, die beim Stand der Technik hohen Kostenaufwand verursachen, gehören bei Anwendung der vorliegenden Erfindung praktisch der Vergangenheit an.

In der Anwendung der Erfindung ist es grundsätzlich möglich, die Beinchen im freien Raum zu biegen, festgelegt auf der einen Seite durch die Klemmung im seitlich zwangsgeführten Klemmwerkzeug und auf der anderen Seite durch Aufnahme des IC-Gehäuses, wobei die Beinchen zur Schonung des IC-Gehäuses in einem an den Rand des IC-Gehäuses anschließenden Abschnitt, ebenfalls eingeklemmt werden können. Die Biegespannungen werden auf diese Weise nicht auf das Gehäuse übertragen.

Da die Beinchen in den meisten Anwendungsfällen in eine Z-förmige Gestalt gebogen werden sollen, wird das Klemmwerkzeug vorzugsweise so geführt, dass die Ausrichtung der eingeklemmten Enden der Beinchen erhalten bleibt, während sie auf dem bogenförmigen Weg zwangsweise seitlich geführt werden, d.h., die Enden der Beinchen bleiben parallel zu der gemeinsamen Ebene, in der sie ursprünglich gelegen haben.

Durch die Beschichtung mit Zinn sind die Beinchen im allgemeinen etwas ungleichmässig. Um dennoch zu gewährleisten, dass die Beinchen auf allen vier Seiten des IC-Gehäuses gleichzeitig fest ergriffen werden, kann vorzugsweise so gearbeitet werden, dass die Beinchen nicht an allen vier Seiten des Gehäuses gemeinsam, sondern getrennt und unabhängig voneinander durch getrennte Klemmwerkzeuge ergriffen und gebogen werden.

Die erfindungsgemässe Vorrichtung benutzt als Klemmwerkzeug zwei Backen, welche neben der Aufnahme des Gehäuses auf die Unterseite und die Oberseite der Beinchen einwirken. Sie sind um Achsen drehbar angeordnet, die parallel zu der gemeinsamen Ebene, in welcher die Beinchen ursprünglich liegen, und rechtwinklig zur Längserstreckung der Beinchen verlaufen, wobei die Achsen quer zu der gemeinsamen Ebene verschiebbar gelagert sind, und zwar nicht einzeln gegeneinander, sondern gemeinsam unter Aufrechterhaltung der Klemmung. Die gemeinsame Ebene, in welcher die Beinchen ursprünglich liegen, ist mittelbar in der erfindungsgemässen Vorrichtung vorhanden, definiert durch die Einrichtung zur Aufnahme des Gehäuses in vorbestimmter Lage.

Durch die längs verschiebliche Lagerung der Backen in Kombination mit ihrer Schwenklagerung wird erreicht, dass die Backen, wenn sie die Enden der Beinchen eingeklemmt haben und dann verschoben werden, zwangsläufig einen bogenförmigen Weg beschreiben, weil sie an den Beinchen, die sie eingeklemmt haben, "hängen" wie an ihrem Lasso. Durch das Auslenken der Biegebacken beim Biegevorgang erhöhen sich durch eine Kniehebelwirkung an den Biegebacken die Kräfte in Richtung der Biegebewegung zur weiteren Ausführung der Biegung. Weitere Führungsmittel für das Klemmwerkzeug sind nicht erforderlich, so dass der Aufbau der erfindungsgemässen Vorrichtung insoweit sehr einfach ist.

Wenn es auch grundsätzlich möglich ist, die Beinchen im freien Raum zu biegen, ist es doch für einen wiederholbaren, gleichmässigen Biegevorgang, der untereinander gleichgestaltete Anschlußbeinchen hervorbringt, vorteilhaft, wenn der Biegebacken an seine Klemmfläche in Richtung gegen die Einrichtung der Gehäuseaufnahme anschließend eine Biegefläche aufweist, an welche sich die Beinchen beim Biegen anlegen können, so dass diese Biegefläche, welche vorzugsweise konvex gerundet ist, die Gestalt der gebogenen Beinchen bestimmt. Diese Biegefläche arbeitet vorzugsweise mit einer Gegenform zusammen, welche einen zur Biegeform komplementären Oberflächenbereich hat, gegen welchen der Biegebacken mit seiner Biegefläche bewegt wird, so dass am Ende des Biegevorgangs die Beinchen auch zwischen der Biegefläche und dem komplementären Oberflächenbereich eingeklemmt sind, wodurch auch der mittlere Bereich der Anschlußbeinchen zwangsläufig eine vorbestimmte Gestalt erhält, aber ohne jegliche Reibung zwischen den Beinchen und der Biegefläche auf der einen Seite und dem komplementären Oberflächenbereich auf der anderen Seite, so dass die Vorteile der Erfindung, die sich aus der Zwangsführung der eingeklemmten Enden der Beinchen ergeben, in vollem Umfang erhalten bleiben.

Der komplementäre Oberflächenbereich wird zweckmässigerweise an der Einrichtung zur Gehäuseaufnahme als Biegematrizenform ausgebildet.

Um den Biegevorgang durch Längsverschiebung der Backen auszulösen, ist es nicht erforderlich, dass beide Backen eine eigene Betätigungseinrichtung haben, es genügt vielmehr, wenn nur einer der Backen durch eine Betätigungseinrichtung vorschiebbar ist und der andere Backen zurückfedernd gelagert ist, so dass er z.B. gegen eine Federkraft zurückweicht, wenn der erste Backen vorgeschoben wird. Natürlich muss die Federkraft ausreichend bemessen sein, um die Enden der Beinchen zwischen den Backen festzuhalten. Zweckmässigerweise ist es der mit der Biegefläche ausgestattete Backen, welcher durch die Betätigungseinrichtung vorschiebbar ist. Für diesen Backen ist vorzugsweise zusätzlich ein Schwenkantrieb vorgesehen, durch welchen der Backen gegen die Einrichtung zur Aufnahme des Gehäuses und der Biegematrizenform zusätzlich angedrückt werden kann. Dieser Schwenkantrieb wird nicht benötigt, um das aus den beiden Backen gebildete Klemmwerkzeug längs des vorbestimmten, bogenförmigen Weges zu bewegen, sondern es soll ermöglichen, dann, wenn der Biegevorgang bereits im wesentlichen abgeschlossen ist und die Beinchen zwischen der Biegefläche und der dazu komplementären Oberfläche liegen, nachzudrücken oder gar etwas zu überbiegen, wenn das im einzelnen Anwendungsfall zweckmässig oder erwünscht sein sollte. Zur Schonung der Beinchen und der Werkzeuge ist der Schwenkantrieb vorzugsweise abgefedert. Somit können die auftretenden Kräfte leicht über die Federkraft bestimmt werden.

Damit die Backen nach erfolgtem Biegevorgang selbsttätig in ihre Ausgangslage zurückschwenken, ist ihnen vorzugsweise jeweils eine Rückstellfeder zugeordnet.

Es wurde bereits erwähnt, dass die aus einer gemeinsamen Seite des Gehäuses herausragenden Beinchen vorzugsweise gemeinsam, aber unabhängig von den anderen Beinchen ergriffen und gebogen werden. Das bedingt in Weiterbildung der Erfindung, dass für ein Gehäuse, aus dessen vier Seiten Beinchen herausragen, vier Paare von erfindungsgemäss gelagerten Backen vorgesehen sind. Die Beinchen einer Seite können an den Enden noch mit einem gemeinsamen Steg verbunden sein, welcher nach dem Formen abgetrennt wird. Um zu einem kompakten und einfachen Werkzeugaufbau zu kommen, sind die auf derselben Seite der Ebene der Beinchen liegenden Backen gemeinsam mit dem auf derselben Seite liegenden Stempel in einem gemeinsamen Gehäuse angeordnet und geführt.

Anstatt die Beinchen zwischen verschwenkbaren Backen zu ergreifen und zu biegen, kann man natürlich auch Backen verwenden, die sowohl in Längsrichtung der Beinchen als auch quer dazu verschiebbar sind, z.B. dadurch, dass man die Backen zwischen zwei weiteren, äußeren, Backen einspannt und darin längsverschieblich lagert, wobei die äußeren Backen quer verschieblich sind.

Zwei Ausführungsbeispiele der Erfindung sind schematisch in den beigefügten Zeichnungen dargestellt.
- Figur 1: zeigt einen Teilschnitt durch eine erfindungsgemässe Vorrichtung, wobei die Schnittebene senkrecht zur gemeinsamen Ebene der Beinchen gelegt ist,
- Figur 2: zeigt als Detail Z aus der Darstellung gemäss Figur 1 den Kernbereich der Vorrichtung mit Klemmwerkzeug und Einrichtung zur Aufnahme des IC-Gehäuses und mit vorgeletem IC, vor dem Biegen der Beinchen,
- Figur 3: zeigt in einer Darstellung wie in Figur 2 die Werkzeuganordnung während des Biegevorgangs,
- Figur 4: zeigt in einer Darstellung entsprechend Figur 2 die Werkzeuganordnung bei vollendetem Biegevorgang, und
- Figur 5: zeigt schematisch in einer Ansicht entsprechend der Figur 2 eine Werkzeuganordnung mit einem abgewandelten Klemmwerkzeug.

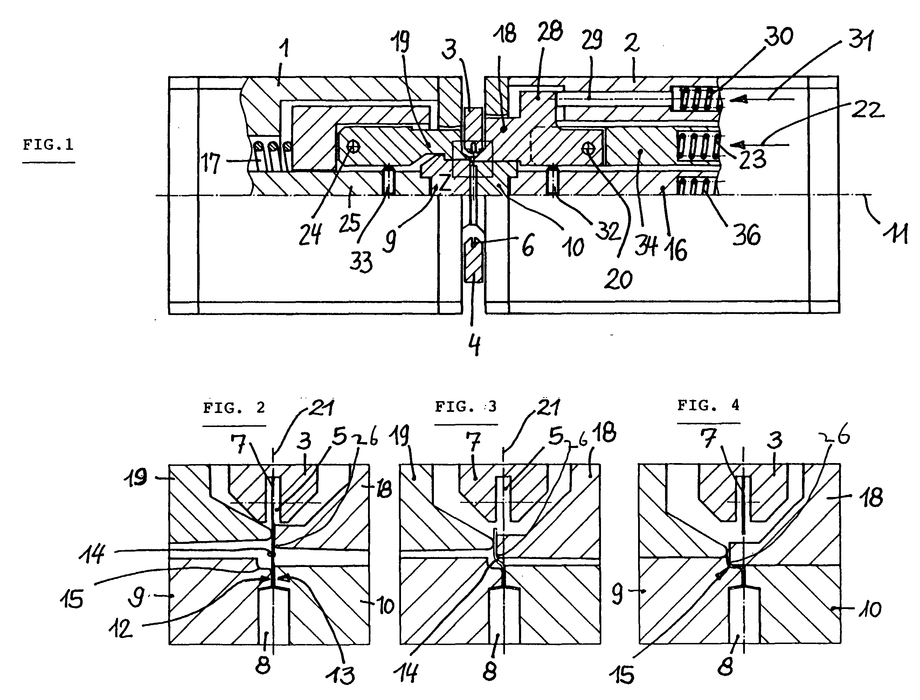

Die in Figur 1 dargestellte Vorrichtung hat zwei Führungsgehäuse 1 und 2, welche mit Abstand zueinander angeordnet sind. Beide Führungsgehäuse 1 und 2 sind auf einer gemeinsamen Werkzeugführung angeordnet und können unabhängig voneinander in Längsrichtung bewegt werden (Pfeile 38 und 39). Im freien Raum zwischn den beiden Gehäusen befinden sich zwei Führungsschienen 3 und 4 mit einander zugewandten, senkrecht zur Zeichenebene verlaufenden Schlitzen 5 und 6 zur Führung eines Leadframes 7 an seinen beiden Längsrändern.

Zur Aufnahme des, mit dem Leadframe verbundenen, aus Kunststoff bestehenden Gehäuses 8 in vorbestimmter Lage, ist im Führungsgehäuse 1 eine Gehäuseaufnahme 9 und im Führungsgehäuse 2 eine Gehäuseaufnahme 10 angeordnet. Die Aufnahme 10 ist in der Längsachse 11 der Anordnung gegen eine Federkraft verschiebbar. Die Ränder 12 und 13 der Gehäuseaufnahmen 10 und 11 umgreifen den Rand des Gehäuses und klemmen die Beinchen am Austritt aus dem Gehäuse. Dieser festgeklemmte Abschnitt steht für den Biegevorgang nicht zur Verfügung.

Die eine Gehäuseaufnahme 9 hat angrenzend an ihre Klemmfläche eine Form 15, in welche die Beinchen 14 mit ihrem mittleren Abschnitt gebogen werden, so dass die Gestalt der Form 15 die spätere Gestalt der Beinchen 14 in diesem Bereich bestimmt. Sie bildet dadurch auch gleichzeitig die Biegematrize.

Zur Aufnahme des Gehäuses 8 und zur Klemmung der Anschlußbeinchen 14 wird die Gehäuseaufnahme 9 über einen Bewegungsmechanismus an das Gehäuse angefahren und in dieser Position gehalten. Die Gehäuseaufnahme 10 wird anschließend über den Stößel 16, welcher rückseitig durch eine Feder 33 abgefedert ist, angefahren und dadurch werden die Beinchen 14 nahe am Gehäuserand eingeklemmt.

Zum Biegen der Beinchen 14 ist ein bewegliches Klemmwerkzeug vorgesehen, welches für jede Gehäuseseite jeweils zwei Backen 18 und 19 hat, welche die Beinchen 14 nahe bei ihren Enden ergreifen und zwischen sich festklemmen. Der Backen 18 ist um eine Achse 20, welche parallel zur ursprünglichen gemeinsamen Ebene 21 und rechtwinkelig zur Längsrichtung der Beinchen 14 verläuft, schwenkbar in der Backenführung 34 gelagert.

Gleichzeitig ist die Backenführung 34 und somit die Achse 20 und mit ihr der Backen 18 von hinten her - symbolisch durch den Pfeil 22 angedeutet - durch eine Betätigungseinrichtung, z.B. einen Druckmittelzylinder oder eine angetriebene Kurvenscheibe, über eine Feder 23 abgestützt, in Längsrichtung 22 verschiebbar in Richtung gegen den anderen Backen 19. Der Backen 19 seinerseits ist um eine zur Achse 20 parallele Achse 24 schwenkbar in der Backenaufnahme 35 gelagert. Die Backenaufnahme 35 wird durch die Feder 17 mit der Klemmkraft (Gegenkraft) beaufschlagt, so dass auch der Backen 19 durch die Feder 17 abgefedert ist.

Der der Form 15 gegenüberliegende Randbereich des Backens 18 dient als Biegefläche 26 und hat deshalb eine zur Ausnehmung 15 komplementäre Gestalt (Form).

Der Backen 18 hat einen seitlichen Ansatz 28, welcher rückseitig unter der Wirkung eines zur Achse 11 parallelen Stößels 29 steht, der unter Zwischenfügen einer Feder 30 von einer nicht weiter dargestellten, durch den Pfeil 31 symbolisierten Betätigungseinrichtung, z.B. ein Druckmittelzylinder, vorgeschoben werden kann, wodurch der Backen zusätzlich mit der Federkraft 30 beaufschlagt und weiter eingeschwenkt werden kann.

Die Vorrichtung arbeitet wie folgt:

Wenn durch Vorschub des Leadframes 7 ein Gehäuse 8 genau zwischen den Gehäuseaufnahmen 9 und 10 positioniert ist, wird es zwischen diesen festgeklemmt, durch die Betätigungseinrichtung 22 der Biegebacken 18 vorgeschoben und die Beinchen 14 an ihren freien Enden zwischen den Backen 18 und 19 eingeklemmt. Bei fortschreitender Vorschubbewegung des Backens 18 weicht der Backen 19 gegen die Federkraft der Feder 17 zurück und beide vollführen, da sie infolge der Klemmung an den Beinchen 14 hängen und schwenkbar gelagert sind, eine bogenförmige Bewegung aus, die ein Biegen der Beinchen in ihrem mittleren Bereich zur Folge hat (Figur 3). Durch das Auslenken der beiden Backen 18 und 19 beim Biegevorgang erhöhen sich durch eine Kniehebelwirkung an den Backen die Kräfte in Richtung der Biegebewegung zur weiteren Ausführung des Biegevorgangs. Dabei schmiegen sich die Beinchen zunächst fortschreitend der Biegefläche 26 an und werden durch diese zum Schluß des Biegevorgangs in die dazu komplementäre Biegeform der Matrize 15 der Biegematrize 9 gedrückt (Figur 4), wobei in diesem Moment durch die Betätigungseinrichtung 31 ein Nachdrücken der Biegefläche 26 in die Ausnehmung 15 hinein erfolgen kann.

Nun werden die Biegebacken 18 und das Klemmstück 10 zurückgezogen, so dass die Backen 18 und 19 nicht mehr klemmen, sondern durch quer zu ihnen gelagerte Federkolben 32 und 33 in ihre Ausgangslage zurückgeschwenkt werden. Sobald der Stempel 10 weit genug zurückgezogen ist, wird der Leadframe 7 mit dem darin hängenden Gehäuse 8 weitertransportiert und das im Leadframe nachfolgende Gehäuse für den Biegevorgang positioniert.

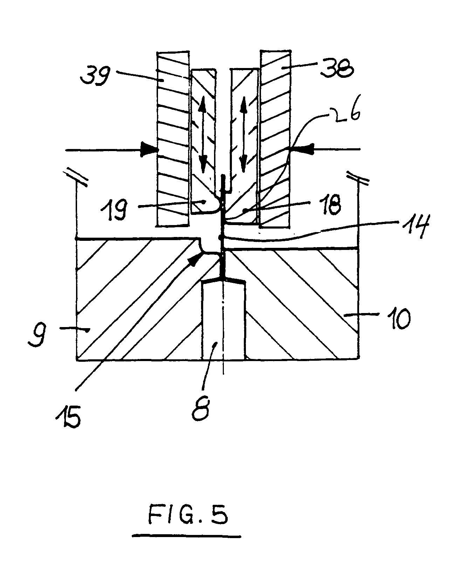

Bei dem in Figur 5 dargestellten Ausführungsbeispiel sind Teile, die Teilen des ersten Ausführungsbeispiels entsprechen, mit übereinstimmenden Bezugszahlen bezeichnet. Das Beispiel gemäss Figur 5 unterscheidet sich von dem gemäss Figur 2 darin, dass die Backen 18 und 19, welche die Beinchen 14 zwischen sich einklemmen, nicht verschwenkbar gelagert sind, sondern längsverschieblich, nämlich in Längsrichtung der Beinchen verschieblich in einem weiteren Paar von Backen 38 und 39 gelagert sind, welche die Backen 18 und 19 zwischen sich einspannen. Die äußeren Backen 38 und 39 sind ihrerseits im rechten Winkel zur Ebene der Beinchen 14 verschiebbar. Werden sie in dieser Richtung vom Stempel 10 in Richtung auf den Stempel 9 verschoben, dann ziehen die eingeklemmten Beinchen 14 die Backen 18 und 19 infolge der fortdauernden Klemmung ein Stück weit aus den Backen 38 und 39 vor, bis die Beinchen 14 in die Ausnehmung 15 hineingedrückt sind. Damit die Backen 18 und 19 nur geringe Reibung in den Backen 38 und 39 erfahren, können sie beispielsweise auf Nadeln verschieblich gelagert sein.

## Patentansprüche

1. Verfahren zum Formen der Anschlußbeinchen von integrierten Schaltkreisen mit einem Gehäuse (8), aus welchem in einer gemeinsamen Ebene (21) liegende Beinchen (14) herausragen, durch Festlegen des Gehäuses (8) und Biegen der Beinchen (14) bei dem die Beinchen (14) von einer Einrichtung (9, 10) zum Festlegen des Gehäuses und in einigem Abstand von diesem Gehäuse von zwei Backen (18, 19) eines Klemmwerkzeugs eingeklemmt werden, wobei dann die Enden der Beinchen (14) unter Aufrechterhaltung der Klemmung in Längsrichtung entlang einem bogenförmigen Weg, welcher in einer die jeweiligen Beinchen (14) enthaltenden, rechtwinkelig zu der gemeinsamen Ebene (21) verlaufende Ebene liegt, zwangsgeführt werden, indem die Backen (18, 19) des Klemmwerkzeugs unter Aufrechterhaltung der Klemmung in Längsrichtung der Beinchen (14) quer zu der gemeinsamen Ebene (21) verschoben werden, und wobei die Beinchen (14) zwischen einer Biegefläche (26) eines der Backen (18) und einer komplementar hier zu gestalteten und schräg gegenüberliegende Gegenform (15) der Einrichtung (9, 10) eingeklemmt werden.

2. Verfahren nach Anspruch 1, dadurch gekennzeichnet, daß die Ausrichtung der Enden der Beinchen (14) i.w. erhalten bleibt, während sie auf dem bogenförmigen Weg geführt werden.

3. Verfahren nach Anspruch 1 oder 2, dadurch gekennzeichnet, daß die zu einer Seite aus dem Gehäuse herausragenden, zueinander parallelen Beinchen (14) gemeinsam ergriffen und gemeinsam gebogen werden, daß aber die von unterschiedlichen Seiten des Gehäuses herausragenden Gruppen von Beinchen (14) unabhängig voneinander ergriffen und gebogen werden.

4. Verfahren nach einem der vorstehenden Ansprüche, dadurch gekennzeichnet, daß die Beinchen (14) unmittelbar neben dem Gehäuse (8) ergriffen und geklemmt werden und dadurch das Gehäuse festgelegt wird.

5. Verfahren nach einem der vorstehenden Ansprüche, dadurch gekennzeichnet, daß die Beinchen (14) nahe bei ihren freien Enden eingeklemmt und dann gebogen werden.

6. Vorrichtung zum Formen der Anschlußbeinchen (14) von integrierten Schaltkreisen mit einem Gehäuse, aus welchem in einer gemeinsamen Ebene (21) liegende Beinchen (14) herausragen, mit einer Einrichtung (9, 10) zum Festlegen des jeweiligen Gehäuses, neben der Einrichtung (9, 10) zum Festlegen des Gehäuses sind zwei Backen (18, 19) eines Klemmwerkzeugs zum Festklemmen von Beinchen (14) angeordnet, wobei einer der Backen (18) an die Klemmfläche in Richtung gegen die Einrichtung (9, 10) zum Festlegen des Gehäuses anschließend eine Biegefläche (26) hat, an welche sich die Beinchen (14) beim Biegen anlegen, so daß diese Biegefläche (26) die Gestalt der gebogenen Beinchen (14) bestimmt, wobei die Einrichtung (9, 10) eine komplementär zu dieser Biegefläche (26) gestaltete und schräg gegenüberliegende Gegenform (15) aufweist, wobei die Backen (18, 19) um Achsen (20, 24) schwenkbar sind, die parallel zu der gemeinsamen Ebene (21) und rechtwinklig zur Längserstreckung der Beinchen (14) verlaufen, und wobei die Achsen (20, 24) unter Aufrechterhaltung der Klemmung quer zu der gemeinsamen Ebene (21) verschiebbar gelagert sind.

7. Vorrichtung zum Formen der Anschlußbeinchen (14) von integrierten Schaltkreisen mit einem Gehäuse, von welchem in einer gemeinsamen Ebene (21) liegende Beinchen (14) herausragen, mit einer Einrichtung (9, 10) zum Festlegen des jeweiligen Gehäuses, neben der Einrichtung (9, 10) zum Festlegen des Gehäuses sind zwei Backen (18, 19) eines Klemmwerkzeugs zum Festklemmen von Beinchen (14) angeordnet, wobei einer der Backen (18) an die Klemmfläche in Richtung gegen die Einrichtung (9, 10) zum Festlegen des Gehäuses anschließend eine Biegefläche (26) hat, an welche sich die Beinchen (14) beim Biegen anlegen, so daß diese Biegefläche (26) die Gestalt der gebogenen Beinchen (14) bestimmt, wobei die Einrichtung (9, 10) eine komplementär zu dieser Biegefläche (26) gestaltete und schräg gegenüberliegende Gegenform (15) aufweist, und wobei die Backen (18, 19) unter Aufrechterhaltung der Klemmung in Längsrichtung der Beinchen (14) sowie quer zu der gemeinsamen Ebene (21) verschiebbar gelagert sind.

8. Vorrichtung nach Anspruch 7, dadurch gekennzeichnet, daß die Backen (18, 19) zwischen zwei quer zu der gemeinsamen Ebene (21) verschiebbaren äußeren Backen (38, 39) eingespannt in Längsrichtung der Beinchen (14) verschiebbar gelagert sind.

9. Vorrichtung nach Anspruch 6, 7 oder 8, **dadurch gekennzeichnet**, daß die Biegefläche (26) konvex gerundet ist.

10. Vorrichtung nach einem der Ansprüche 6 bis 9, **dadurch gekennzeichnet**, daß die Einrichtung (9, 10) zum Festlegen des Gehäuses zwei gegeneinander arbeitende Aufnahmen (9, 10) zur Anlage an der Oberseite und der Unterseite des Gehäuses hat.

11. Vorrichtung nach einem der Ansprüche 6 bis 10, **dadurch gekennzeichnet**, daß die Backen (18, 19) relativ zu der Einrichtung (9, 10) so angeordnet sind, dass sie die Beinchen (14) in einigem Abstand vom Gehäuse (8) festklemmen, vorzugsweise nahe bei ihren freien Enden.

12. Vorrichtung nach einem der Ansprüche 10 und 11, **dadurch gekennzeichnet,** dass die Aufnahmen (9, 10) Vorsprünge (12, 13) haben, die an den Gehäuserändern vorbeigreifen, um die Beinchen (14) am Rand des Gehäuses (8) zu ergreifen und zu klemmen.

13. Vorrichtung nach Anspruch 6, **dadurch gekennzeichnet**, daß der eine Backen (18) in Längsrichtung im Führungsgehäuse (2) verschiebbar ist und der andere Backen (19) zurückfedernd gelagert ist.

14. Vorrichtung nach Anspruch 13, **dadurch gekennzeichnet**, daß der mit der Biegefläche (26) ausgestattete Backen (18) durch eine Betätigungseinrichtung (31) vorschiebbar ist.

15. Vorrichtung nach Anspruch 6, **dadurch gekennzeichnet**, daß für den mit der Biegefläche (26) ausgestatteten Backen (18) zusätzlich ein Schwenkantrieb (29, 30, 31) für eine gegen die Einrichtung (9, 10) zur Aufnahme des Gehäuses (8) gerichtete Schweakbewegung vorgesehen ist.

16. Verrichtung nach Anspruch 15, **dadurch gekennzeichnet**, daß der Schwenkantrieb (29, 30, 31) abgefedert (30) ist.

17. Vorrichtung nach einem der Ansprüche 6, 13 bis 16, **dadurch gekennzeichnet**, daß den Backen (18, 19) Rückstellfedern (32, 33) zugeordnet sind.

18. Vorrichtung nach einem der Ansprüche 6 bis 17, **dadurch gekennzeichnet**, daß für die Gruppe der aus einer gemeinsamen Seite des Gehäuses herausragenden Beinchen (14) jeweils ein gemeinsames Paar von Backen (18, 19) vorgesehen ist.

19. Vorrichtung nach Anspruch 18, **dadurch gekennzeichnet**, dass die Paare von Backen (18, 19) unabhängig betätigbar sind.

20. Vorrichtung nach einem der Ansprüche 6 und 13-17, **dadurch gekennzeichnet**, daß die Einrichtung (9, 10) zum Festlegen des Gehäuses gegeneinander arbeitende Aufnahmen (9, 10) zur Anlage an der Oberseite und der Unterseite des Gehäuses hat, und die auf derselben Seite der Ebene (21) der Beinchen (14) liegenden Backen (18) gemeinsam mit dem auf derselben Seite liegenden Aufnahme (10) in einem gemeinsamen Gehäuse (2) geführt sind.

## Claims

1. Method for forming the connection leads of integrated circuits with a housing (8), from which there are protruding leads (14), which are positioned in a common plane (21), by holding in place the housing (8) and bending the leads (14), wherein the leads (14) are clamped by means (9, 10) for holding in place the housing and in some distance from this housing by two jaws (18, 19) of a clamping tool, wherein then the tips of the leads (14) while remaining clamped in their longitudinal direction are positively moved along a curved path, which is situated in a plane containing the respective leads (14) and being orientated orthogonal to the common plane (21), by moving the jaws (18, 19) of the clamping tool transversely to the common plane (21) while maintaining the clamping in longitudinal direction of the leads (14), and wherein the leads (14) are clamped between a bending surface (26) of one of the jaws (18) and a counterform (15) of the means (9, 10) which is shaped complementarily to and positioned diagonally opposite to the bending surface (26).

2. The method according to claim 1, characterized in that the alignment of the tips of the leads (14) is generally maintained while they are moved along the curved path.

3. The method according to claim 1 or 2, characterized in that the leads (14) protruding from the housing to one side and being parallel to each other are jointly gripped and jointly bent, and that the groups of leads (14) protruding from different sides of the housing are gripped and bent separately from each other.

4. The method according to one of the preceding claims, characterized in that the leads (14) are gripped and clamped in the proximity of the housing (8), thereby holding the housing in place.

5. The method according to one of the preceding claims, characterized in that the leads (14) are clamped in the vicinity of their tips and are subsequently bent.

6. Device for forming the connection leads (14) of integrated circuits with a housing, from which there are protruding leads (14) which are positioned in a common plane (21), having means (9, 10) for holding in place the respective housing, besides the means (9, 10) for holding in place the housing there are provided two jaws (18, 19) of a clamping tool for the clamping of leads (14), one of the jaws (18) having a bending surface (26) adjoining the clamping surface in the direction towards the means (9, 10) for holding in place the housing, against which the leads (14) put upon bending, so that this bending surface (26) determines the shape of the bent leads (14), the means (9, 10) having a counterform (15) shaped complementarily to and positioned diagonally opposite to this bending surface (26), the jaws (18, 19) being pivotable around axes (20, 24) which extend parallel to the common plane (21) and orthogonal to the longitudinal direction of the leads (14), and the axes (20, 24) being mounted movably transversely to the common plane (21) while maintaining the clamping.

7. Device for forming the connection leads (14) of integrated circuits with a housing, from which there are protruding leads (14) which are positioned in a common plane (21), with means (9, 10) for holding in place the respective housing, besides the means (9, 10) for holding in place the housing two jaws (18, 19) of a clamping tool for the clamping of leads (14) are provided, one of the jaws (18) having a bending surface (26) adjoining the clamping surface in the direction towards the means (9, 10) for holding in place the housing, against which the leads (14) put upon bending, so that this bending surface (26) determines the shape of the bent leads (14), the means (9, 10) having a counterform (15) shaped complementarily to and positioned diagonally opposite to this bending surface (26), and the jaws (18, 19) being mounted movably in the longitudinal direction of the leads (14) and transversely to the common plane (21) while maintaining the clamping.

8. The device according to claim 7, characterized in that the jaws (18, 19) are movably mounted in longitudinal direction of the leads (14) while being held between two outer jaws (38, 39) being movable transversely to the common plane (21).

9. The device according to claim 6, 7 or 8, characterized in that the bending surface (26) is curved convexly.

10. The device according to one of the claims 6 to 9, characterized in that the means (9, 10) for holding in place the housing has two receptions (9, 10) cooperating for contacting the upper side and the lower side of the housing.

11. The device according to one of the claims 6 to 10, characterized in that the jaws (18, 19) are arranged relative to the means (9, 10) in a way that they clamp the leads (14) in some distance from the housing (8), preferably near their tips.

12. The device according to one of the claims 10 and 11, characterized in that the receptions (9, 10) have protrusions (12, 13) which grip past the edges of the housing, in order to grip and clamp the leads (14) at the edge of the housing (8).

13. The device according to claim 6, characterized in that the one jaw (18) is movable in longitudinal direction in the guide housing (2) and the other jaw (19) is movable in backward direction against the action of a spring.

14. The device according to claim 13, characterized in that the jaw (18) provided with the bending surface (26) is movable in forward direction by an actuator (31).

15. The device according to claim 6, characterized in that for the jaw (18) provided with the bending surface (26) additionally a pivoting drive (29, 30, 31) is provided for a pivoting motion directed towards the means (9, 10) for receiving the housing (8).

16. The device according to claim 15, characterized in that the pivoting drive (29, 30, 31) is spring-supported (30).

17. The device according to one of the claims 6, 13 to 16, characterized in that reset springs (32, 33) are assigned to the jaws (18, 19).

18. The device according to one of the claims 6 to 17, characterized in that for the group of the leads (14) protruding from a common side of the housing a respective common pair of jaws (18, 19) is provided.

19. The device according to claim 18, characterized in that the pairs of jaws (18, 19) can be actuated separately.

20. The device according to one of the claims 6 and 13 to 17, characterized in that the means (9, 10) for holding in place the housing has receptions (9,10) cooperating for contacting the upper side and the lower side of the housing, and that the jaws (18) provided on the same side of the plane (21) of the leads (14) are guided together with the reception (10) provided on the same side in a common housing (2).

## Revendications

1. Procédé de formage des conducteurs de raccordement de circuits intégrés comportant un boîtier (8) duquel sortent des conducteurs (14) situés dans un plan commun (21), en fixant le boîtier (8) et en cambrant les conducteurs (14) où les conducteurs (14) sont maintenus serrés par un dispositif (9,10) assurant la fixation du boîtier (8) et à une distance appropriée de ce boîtier par deux mâchoires (18,19) d'un outil de serrage, à l'occasion de quoi les parties extrêmes des conducteurs (14), tout en étant maintenues serrées dans la direction longitudinale, sont ensuite déplacées suivant un trajet courbe qui est situé dans un plan contenant les conducteurs respectifs (14) et qui est perpendiculaire au plan commun (21), pendant que les mâchoires (18,19) de l'outil de serrage, maintenant le serrage des conducteurs (14) dans la direction longitudinale, sont déplacées perpendiculairement au plan commun (21), et à l'occasion de quoi les conducteurs (14) sont serrés entre une surface de cambrage (26) de l'une des mâchoires (18) et une surface contrepartie (15) de forme complémentaire, l'épousant étroitement, du dispositif (9,10).

2. Procédé suivant la revendication 1 **caractérisé en ce que** la direction d'extension des parties extrêmes des conducteurs (14) est maintenue constante tandis qu'elles sont déplacées le long du trajet courbe.

3. Procédé suivant la revendication 1 ou 2 **caractérisé en ce que** les conducteurs (14) parallèles entre eux, sortant d'un côté du boîtier, sont saisis en commun et cambrés en commun mais les groupes de conducteurs (14) sortant d'un côté différent des boîtiers sont saisis et cambrés indépendamment les uns des autres.

4. Procédé suivant l'une quelconque des revendications précédentes **caractérisé en ce que** les conducteurs (14) sont saisis et serrés directement à côté du boîtier (8) et en ce que, de ce fait, le boîtier est fixé.

5. Procédé suivant l'une quelconque des revenécédentes **caractÂsé en ce que** les conducteurs (14) sont serrés à proximité de leurs parties extrêmes libres et sont ensuite cambrés.

6. Dispositif de formage des conducteurs de raccordement (14) de circuits intégrés comportant un boîtier dont sortent des conducteurs (14) situés dans un plan commun (21), comprenant un dispositif (9,10) pour fixer le boîtier, outre le dispositif (9,10) de fixation du boîtier deux mâchoires (18,19) d'un outil de serrage pour le serrage des conducteurs (14) sont situées, une des mâchoires (18) comportant, à côté de la surface de serrage en direction du dispositif (9,10) assurant la fixation du boîtier, une surface de cambrage (26) sur laquelle sont appliqués les conducteurs (14), lors du cambrage, de telle façon que cette surface de cambrage (26) détermine la forme des conducteurs courbés (14), le dispositif (9,10) présentant une surface contrepartie (15) de forme complémentaire de la surface de cambrage (26) et épousant étroitement celle-ci, les mâchoires (18,19) étant montées pivotantes autour d'axes (20,24) qui sont parallèles au plan commun (21) et perpendiculaires à la direction longitudinale des conducteurs (14), et les axes (20,24) étant montés de manière à pouvoir se déplacer perpendiculairement au plan commun (21), tout en maintenant le serrage.

7. Dispositif de formage des conducteurs de raccordement (14) de circuits intégrés comportant un boîtier dont sortent des conducteurs (14) situés dans un plan commun (21), comprenant un dispositif (9,10) pour fixer le boîtier, outre le dispositif (9,10) de fixation du boîtier deux mâchoires (18,19) d'un outil de serrage pour le serrage des conducteurs (14) sont situées, l'une des mâchoires (18) comporte, à côté de la surface de serrage en direction du dispositif (9,10) assurant la fixation du boîtier, une surface de cambrage (26) sur laquelle sont appliqués les conducteurs (14), lors du cambrage, de telle façon que cette surface de cambrage (26) détermine la forme des conducteurs courbés (14), le dispositif (9,10) présentant une surface contrepartie (15) de forme complémentaire de la surface de cambrage (26) et épousant étroitement celle-ci, et les mâchoires (18,19) étant montées de manière à pouvoir se déplacer, tout en maintenant le serrage, à la fois dans la direction longitudinale des conducteurs (14) et perpendiculairement au plan commun (21).

8. Dispositif selon la revendication 7 **caractérisé en ce que** les mâchoires (18,19) sont montées à coulissement, dans la direction longitudinale des conducteurs (14), en étant encastrées entre deux mâchoires externes (38,39) pouvant se déplacer perpendiculairement au plan commun (21).

9. Dispositif suivant la revendication 6, 7 ou 8 **caractérisé en ce que** la surface de cambrage (26) est arrondie convexement.

10. Dispositif suivant l'une des revendications 6 à 9 **caractérisé en ce que** le dispositif (9,10) de fixation du boîtier comporte deux supports (9,10) fonctionnant dans des sens opposés pour un appui sur le côté supérieur et sur le côté inférieur du boîtier.

11. Dispositif suivant l'une des revendications 6 à 10 **caractérisé en ce que** les mâchoires (18,19) sont disposées, par rapport au dispositif de fixation (9,10), de telle façon qu'elles serrent les conducteurs (14) à faible distance du boîtier (8) et avantageusement à proximité de leurs extrémités libres.

12. Dispositif suivant l'une quelconque des revendications 10 et 11 **caractérisé en ce que** les supports (9,10) comportent des saillies (12,13) qui s'étendent le long du bord du boîtier afin de saisir et de serrer les conducteurs (14) à l'endroit du bord du boîtier (8).

13. Dispositif suivant la revendication 6 **caractérisé en ce que** l'une des mâchoires (18) peut se déplacer, dans la direction longitudinale (22), dans un corps de guidage (2) et l'autre mâchoire (19) est montée de manière à être rappelée par un ressort.

14. Dispositif suivant la revendication 13 **caractérisé en ce que** la mâchoire (18) présentant la surface de cambrage (26) peut être déplacée par un actionneur (31).

15. Dispositif suivant la revendication 6 **caractérisé en ce que** pour la mâchoire (18) présentant la surface de cambrage (26) il est prévu un mécanisme de pivotement (29,30,31) pour provoquer un mouvement de pivotement dirigé vers le dispositif (9,10) de fixation du boîtier (8).

16. Dispositif suivant la revendication 15 **caractérisé en ce que** le mécanisme de pivotement (29,30,31) est soumis à l'action d'un ressort (30).

17. Dispositif suivant l'une quelconque des revendications 6 et 13 à 16 **caractérisé en ce que** des ressorts de rappel (32,33) sont associés aux mâchoires (18,19).

18. Dispositif suivant l'une quelconque des revendications 6 à 17 **caractérisé en ce qu**'il est prévu, pour le groupe de conducteurs (14) sortant d'un même côté du boîtier, une paire commune de mâchoires (18,19).

19. Dispositif suivant la revendication 18 **caractérisé en ce que** les paires de mâchoires (18,19) peuvent être actionnées indépendamment les unes des autres.

20. Dispositif suivant l'une quelconque des revendications 6, et 13 à 17 **caractérisé en ce que** le dispositif (9,10) de fixation du boîtier comporte des supports (9,10) fonctionnant en opposition pour prendre appui sur le côté supérieur et sur le côté inférieur du boîtier et les mâchoires (18) se trouvant du même côté du plan (21) des conducteurs (14) sont guidées en commun, avec le support (10) du même côté, dans un corps commun (2).
